# FASCICULE DE BREVET EUROPEEN

(11) **EP 3 672 230 B1**
(45) Date de publication et mention de la délivrance du brevet: **24.02.2021**
(21) Numéro de dépôt: 19218197.2
(22) Date de dépôt: 19.12.2019
(51) Int. Cl.: H04N 5/376, H04N 5/32, H04N 5/378

(54) **DÉTECTEUR MATRICIEL À CONDUCTEURS DE LIGNE D'IMPÉDANCE MAÎTRISÉE**
MATRIXDETEKTOR MIT LEITERN MIT GESTEUERTER IMPEDANZ
MATRIX DETECTOR WITH CONTROLLED IMPEDANCE LINE CONDUCTORS

(30) Priorité: 21.12.2018 FR 1873891
(43) Date de publication de la demande: 24.06.2020
(73) Titulaire: Trixell, 38430 Moirans (FR)
(72) Inventeur: MARECAUX, Simon, 38430 MOIRANS (FR); BLANCHON, David, 38430 MOIRANS (FR); SIAUD, Martin, 38430 MOIRANS (FR)
(74) Mandataire: Marks & Clerk France

(56) Documents cités:
- US-A1- 2006 001 918
- US-A1- 2007 146 514
- US-A1- 2012 086 826

## Description

La présente invention concerne un détecteur matriciel. L'invention trouve une utilité dans la réalisation d'images visibles mais n'est pas limitée à ce domaine. On peut par exemple réaliser des cartographies de pression ou de température ou encore des représentations en deux dimensions de potentiels chimiques ou électriques. Ces cartographies ou représentations forment des images de grandeurs physiques. L'invention s'applique notamment à des détecteurs à matrices actives utilisés par exemple à des fins de détection dans des dispositifs d'imagerie par rayonnements ionisants, par exemple par rayons X, telles que des dalles de type TFT, selon le sigle désignant la terminologie anglo-saxonne : « Thin Film Transistor » ou transistor en couches minces.

Dans un détecteur matriciel, un pixel représente l'élément sensible élémentaire du détecteur. Chaque pixel convertit un phénomène physique auquel il est soumis en un signal électrique. Les signaux électriques issus des différents pixels sont collectés lors d'une phase de lecture de la matrice puis numérisés de manière à pouvoir être traités et stockés pour former une image. Les pixels sont formés d'une zone sensible au phénomène physique et délivrent par exemple un courant de charges électriques. Le phénomène physique peut être un rayonnement électromagnétique véhiculant un flux de photons et par la suite, l'invention sera expliquée au moyen de ce type de rayonnement et le courant de charge est fonction du flux de photons reçu par la zone sensible. La généralisation à tout détecteur matriciel sera aisée.

Un détecteur d'images matriciel comprend des conducteurs de ligne, chacun reliant les pixels d'une même ligne, et des conducteurs de colonnes, chacun reliant les pixels d'une même colonne. Les conducteurs de colonnes sont connectés à des circuits de conversion généralement disposés sur un bord de la matrice que l'on peut appeler « pied de colonne ».

Chaque pixel comprend généralement un élément photosensible, ou photodétecteur, qui peut par exemple être une photodiode, une photorésistance ou un phototransistor. On trouve des matrices photosensibles de grandes dimensions qui peuvent posséder plusieurs millions de pixels organisés en lignes et en colonnes. Chaque pixel comprend en outre un circuit électronique constitué par exemple d'interrupteurs, capacités, résistances, en aval duquel est placé un actionneur. L'ensemble constitué par l'élément photosensible et le circuit électronique permet de générer des charges électriques et de les collecter. Le circuit électronique permet généralement la réinitialisation de la charge collectée dans chaque pixel après un transfert de charge. Le rôle de l'actionneur est de transférer ou de recopier les charges collectées par le circuit dans un conducteur de colonne. Ce transfert est réalisé lorsque l'actionneur en reçoit l'instruction d'un conducteur de ligne. La sortie de l'actionneur correspond à la sortie du pixel. Les appellations « conducteur de ligne » et « conducteur de colonne » sont purement arbitraires. Il est bien entendu possible d'inverser ces appellations.

Dans ce type de détecteur, un pixel fonctionne selon deux phases : une phase de prise d'image, durant laquelle le circuit électronique du pixel accumule les charges électriques générées par l'élément photosensible, et une phase de lecture, au cours de laquelle les charges collectées sont transférées ou recopiées dans le conducteur de colonne, grâce à l'actionneur.

Lors de la phase de lecture, une instruction de lecture est émise vers tous les actionneurs d'une même ligne de la matrice au moyen d'un conducteur de ligne. Chacun des pixels de cette ligne est lu en transférant son information électrique, charge, tension, courant, fréquence... au conducteur de colonne auquel il est associé.

Pour une trame d'image, les lignes de pixels peuvent être sélectionnées en séquence, l'une après l'autre suivant un sens de balayage des lignes de la matrice, pendant un temps de sélection de ligne correspondant à une fraction de la durée de la trame, permettant l'application sur les pixels de la ligne considérée de signaux appropriés, par exemple des tensions. Ainsi la sélection d'une ligne correspond à l'application pendant un temps de sélection de ligne correspondant, d'un signal de niveau haut commandant l'état passant des dispositifs de commutation de la ligne de pixels correspondante. En dehors du temps de sélection de la ligne, les dispositifs de commutation sont maintenus à un état bloqué via l'application d'un signal de niveau bas approprié. Par exemple, lorsque les dispositifs de commutation sont des transistors, les signaux à appliquer étant alors des tensions, il est habituel de désigner VGon la tension correspondant au niveau haut et partant à l'état passant du transistor de commutation, et VGoff la tension correspondant au niveau bas et à l'état bloqué du transistor de commutation.

La commande des lignes peut être assurée par des circuits de commande comprenant un ou plusieurs registres à décalage en série, chacun des registres à décalage comprenant une pluralité d'étages en cascade, chaque étage étant apte à commuter les niveaux haut et bas du signal appliqué aux actionneurs des pixels d'une ligne correspondante de la matrice, selon le séquencement de la sélection des lignes, par exemple selon un balayage vertical. Les circuits de commande peuvent être mis en œuvre dans des circuits intégrés, un même circuit intégré pouvant par exemple comprendre une pluralité de circuits de commande pour une pluralité de lignes de la matrice. Les circuits intégrés peuvent par exemple être extérieurs à la matrice, et se connecter à celle-ci par des moyens filaires, par exemple des nappes flexibles. Les circuits de commande peuvent également être implantés sur la dalle portant les pixels comme décrit dans la demande de brevet WO 2012/152836 déposée au nom de la demanderesse.

Ceci permet de réduire le nombre de signaux appliqués à la dalle et donc la taille et le nombre des connecteurs souples servant à relier la dalle à son environnement électronique. Cette architecture de circuits de commande intégrés apporte une simplification notable de l'architecture du détecteur par la réduction du nombre de composants et la simplification du procédé de fabrication. Cependant, le schéma décrit dans la demande de brevet WO 2012/152836 a l'inconvénient de laisser en état « haute impédance » toutes les lignes non sélectionnées. En effet, pendant le cycle de lecture de la matrice les circuits de commande appliquent successivement les tensions VGon puis VGoff sur les lignes puis laisse ces lignes au niveau VGoff sans assurer que ce potentiel est maintenu ou stabilisé en cas de perturbation extérieure. Les modifications de tensions des lignes et colonnes adjacents peuvent ainsi créer des phénomènes de diaphonies connu dans la littérature anglo-saxonne sous le nom de « crosstalk » par couplage capacitif entre les lignes laissées au niveau VGoff en état haute impédance et des éléments voisins dont le potentiel évolue au cours du cycle de lecture. L'intégration des circuits de commande sur la dalle portant les pixels tend à augmenter la diaphonie et dégrade la qualité d'image issue du détecteur.

L'état « haute impédance » des conducteurs de ligne entraîne également des perturbations en cas de ligne coupée. Plus précisément, dans les matrices de grandes dimensions, il est possible d'accepter certains défauts de fabrication, entrainant le non fonctionnement de quelques lignes de pixels. Une ligne peut être coupée par exemple lorsqu'un des circuits de commande n'est pas fonctionnel. Il est possible de corriger l'image par extrapolation des lignes adjacentes non coupées. Cependant, la ligne coupée peut perturber les lignes adjacentes. Cette perturbation est liée au fait qu'une partie de la ligne n'est pas adressée et reste en permanence à l'état haute impédance pendant la phase de lecture

Par exemple la demande de brevet US 2012/086826 A1 divulgue une matrice de pixels dans laquelle un conducteur de ligne est piloté par un transistor qui délivre un niveau haut et un niveau bas. Le conducteur de ligne est initialisé avant la lecture par un autre transistor, disjoint, qui abaisse ponctuellement son impédance (pulldown), puis il est laissé en haute impédance.

L'invention vise à pallier tout ou partie des problèmes cités plus haut en proposant un détecteur matriciel évitant que des conducteurs de ligne ne restent à l'état haute impédance.

A cet effet, l'invention a pour objet un détecteur matriciel comprenant :
- un ensemble de pixels sensibles à un phénomène physique et organisés en matrice selon des lignes et des colonnes, chaque pixel générant un signal fonction du phénomène physique,
- des conducteurs de ligne permettant chacun de piloter les pixels d'une ligne,
- des modules de pilotage délivrant des signaux de sélection aux conducteurs de ligne, les modules de pilotages étant configurés pour délivrer des signaux selon deux niveaux dont un niveau haut permettant la sélection d'une des lignes de pixels et un niveau bas ne permettant pas sa sélection.

Selon l'invention, le dispositif comprend en outre des modules d'impédance connectés à chacun des conducteurs de ligne et configurés pour abaisser l'impédance de chaque conducteur de ligne et maintenir en basse impédance chaque conducteur de ligne, pendant une phase de lecture de l'ensemble de pixels, tant que le signal de sélection correspondant est au niveau bas, les modules d'impédance étant disjoints des modules de pilotage.

Chaque conducteur de ligne comprend deux extrémités. Les modules de modules de pilotage sont connectés aux conducteurs de ligne à une première des extrémités et les modules d'impédance sont avantageusement connectés à chacun des conducteurs de ligne à une seconde des extrémités.

L'ensemble de pixels, les modules de pilotage et les modules d'impédance sont avantageusement réalisés sur le même substrat.

Les modules d'impédance comprennent avantageusement chacun un transistor pouvant connecter la ligne correspondante à une source de tension correspondant au niveau bas du signal de sélection lorsque la ligne n'est pas sélectionnée, abaissant ainsi l'impédance de la ligne au travers du transistor.

L'ensemble de pixels, les modules de pilotage et les modules d'impédance comprennent avantageusement des transistors à couches minces.

Le détecteur comprend avantageusement deux modules d'impédance par conducteur de ligne, les deux modules d'impédance pouvant être utilisés alternativement.

L'invention sera mieux comprise et d'autres avantages apparaîtront à la lecture de la description détaillée d'un mode de réalisation donné à titre d'exemple, description illustrée par le dessin joint dans lequel :
la figure 1 représente un exemple de matrices de pixels pouvant être mis en œuvre dans un détecteur selon l'invention ;
la figure 2 représente un exemple de détecteur selon l'invention ;
la figure 3 illustre un avantage de l'invention lorsque des conducteurs de ligne du détecteur sont coupés ;
la figure 4 représente un exemple de module d'impédance pouvant être mis en œuvre dans un détecteur selon l'invention ;
la figure 5 illustre sous forme de chronogramme le fonctionnement du module d'impédance de la figure 4 ;
la figure 6 représente une variante de module d'impédance pouvant être mis en œuvre dans un détecteur selon l'invention.

Par souci de clarté, les mêmes éléments porteront les mêmes repères dans les différentes figures

La description qui suit est faite en rapport avec un détecteur matriciel comprenant plusieurs circuits électroniques élémentaires appelés pixels comprenant chacun un élément sensible à une grandeur physique. Les circuits électroniques élémentaires sont, dans l'exemple décrit, des pixels sensibles à un rayonnement lumineux. Il est bien entendu que l'invention peut être mise en œuvre pour d'autres détecteurs sensibles à toute forme de grandeur physique permettant par exemple de réaliser une cartographie de pression ou de température.

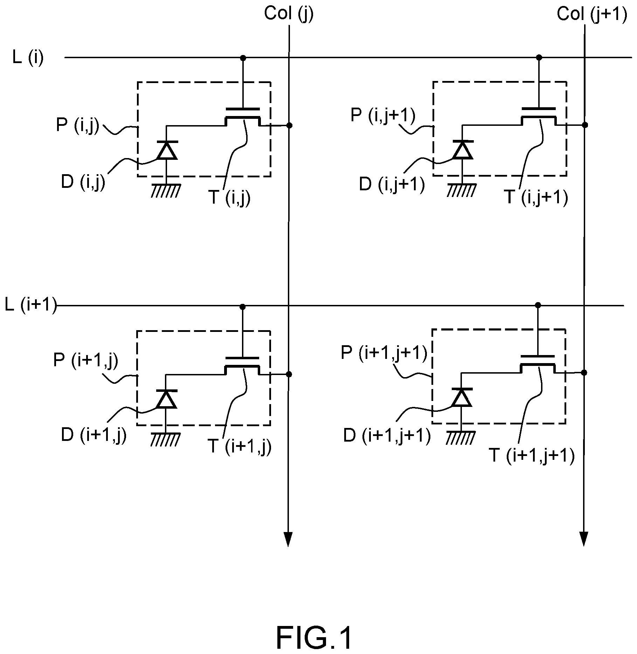

La figure 1 représente schématiquement la zone de détection 10 d'un détecteur matriciel. Cette zone comprend une matrice de deux lignes et deux colonnes pour simplifier la compréhension. Quatre pixels P sont formés, chacun à l'intersection d'une ligne et d'une colonne. Il est bien entendu que les matrices réelles sont généralement beaucoup plus grandes et possèdent un grand nombre de lignes et de colonnes. La matrice de pixels appartient à un détecteur matriciel 12 permettant de réaliser des images numérisées.

Chaque pixel P comprend une zone photosensible, représentée ici par une photodiode D, et un circuit électronique de traitement formé, dans l'exemple de la figure 1, par un seul transistor T. Les références des composants D et T sont suivis de deux coordonnées précisant le rang de la ligne, respectivement i et i+1, et celui de la colonne respectivement j et j+1. Les pixels représentés sont aussi appelés pixel de type 1T car possédant chacun un transistor dont la fonction va être décrite plus loin.

De façon générale, il est connu de réaliser des matrices de pixels comprenant des transistors à effet de champ à couches minces connus dans la littérature anglo-saxonne sous le nom de TFT pour : « Thin-film transistor ». Les transistors de type TFT peuvent être à base d'oxydes métalliques comme par exemple les transistors à base d'oxyde amorphe ou cristallin d'indium, de gallium et de zinc connus sous leur abréviation anglo-saxonne : IGZO. D'autres familles de transistors de type TFT peuvent être mises en œuvre comme par exemple les TFT organiques, les TFT en silicium amorphe, les TFT en silicium poly cristallin. Dans ce dernier type de transistor TFT, certains ont été synthétisés à basse température. Ils sont connus sous leur abréviation anglo-saxonne : LTPS pour « Low-temperature polycrystalline silicon ».

L'invention ne se limite pas à ce type de transistors. On peut par exemple la mettre en œuvre pour des matrices comprenant des transistors à base de semi-conducteurs complémentaires en silicium cristallin connus dans la littérature anglo-saxonne par leur abréviation CMOS pour : « Complementary Metal Oxide Semiconductor ».

Les pixels P d'une même colonne sont raccordés à un conducteur de colonne Col. Ce conducteur permet le recueil d'informations provenant des pixels qui lui sont reliés. Les pixels P d'une même ligne sont raccordés à un conducteur de ligne L véhiculant un signal VG permettant de commander la ligne de pixels correspondante.

Lors d'une phase de prise d'image, intervenant après une opération de remise à zéro, l'éclairement reçu par la photodiode D fait décroître le potentiel de sa cathode. Cette phase de prise d'image est suivie d'une phase de lecture pendant laquelle, on lit le potentiel de la photodiode D. Pour ce faire, on rend passant le transistor T, qui a donc un rôle d'interrupteur commandé par le signal de commande VG appliquée à sa grille.

Le conducteur de colonne Col est utilisé pour le recueil d'information provenant d'un pixel de la colonne correspondante lorsque celui-ci est sélectionné au moyen du signal VG.

Il est possible de mettre en œuvre l'invention dans un détecteur dont les pixels sont plus simples, notamment en remplaçant le transistor T par une simple diode mise en conduction au moyen du signal VG. Il est également possible de mettre en œuvre l'invention dans un détecteur dont les pixels comprennent plusieurs transistors. Il est notamment connu de mettre en œuvre des pixels de type 3T comprenant en complément du transistor de lecture décrit plus haut, un transistor de remise à zéro de la photodiode et un transistor suiveur. Dans ce type de pixel 3T, un second conducteur de ligne véhicule un signal de remise à zéro permettant de commander le transistor de remise à zéro.

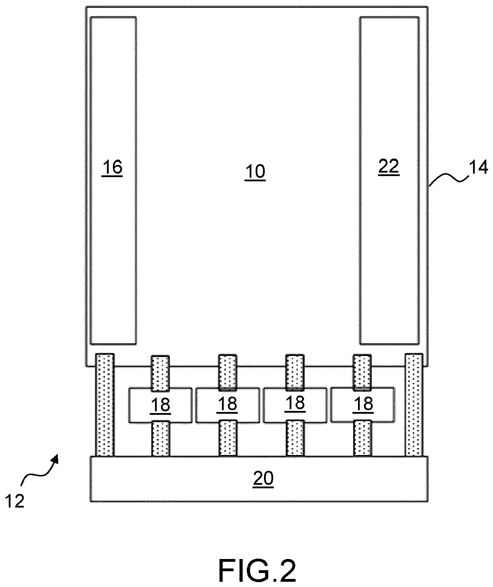

La figure 2 représente schématiquement le détecteur 12 dans son ensemble. Le détecteur 12 comprend une dalle 14 formant le substrat sur lequel sont réalisés les composants de la zone de détection 10. Sur cette même dalle 14 sont disposés des modules de pilotage 16 délivrant des signaux de commande à tous les conducteurs de ligne L. Les modules de pilotage 16 comprennent par exemple des registres à décalage permettant de générer les signaux de commandes. Alternativement les modules de pilotage 16 peuvent être réalisés sur un substrat distinct de la dalle 14. Cependant la réalisation des modules de pilotage 16 sur le même substrat que les pixels P permet de limiter les connexions reliant la dalle 14 à son environnement.

Le détecteur 12 comprend des circuits de lecture 18 reliés aux conducteurs de colonne Col. Les circuits de lecture 18 sont, quant à eux, généralement réalisés sur des substrats distincts de la dalle 14. Les circuits de lecture 18 sont reliés à la dalle 14 au moyen de nappes.

Le détecteur 12 comprend un circuit 20 permettant de piloter les modules de pilotage 16 et permettant de récupérer les signaux issus des circuits de lecture 18, notamment pour les multiplexer.

Selon l'invention, le détecteur 12 comprend des modules d'impédance 22 connectés à chacun des conducteurs de ligne L. Comme pour les modules de pilotage 16, les modules d'impédance 22 sont avantageusement réalisés sur la dalle 14 afin de limiter les connexions extérieures à la dalle 14.

L'invention est décrite en relation avec une matrice de pixels de type 1T ne possédant qu'un seul conducteur L par ligne de pixel. Il est également possible de mettre en œuvre l'invention pour des matrices, notamment formées de pixels 3T, et possédant plusieurs conducteurs de commande par ligne de pixels. Dans ce cas, des modules d'impédance pourront être associés à tous les conducteurs de lignes.

Pour piloter les transistors de lecture T, les modules de pilotage 16 génèrent des signaux binaires dont un niveau haut permet la lecture d'une ligne de pixel et un niveau bas ne permet pas la lecture de la ligne. Les appellations « niveaux haut » et « niveau bas » sont purement arbitraires et sont uniquement utilisées pour distinguer les tensions appliquées au conducteur de ligne. Ces appellations peuvent bien entendu être inversées. Les modules de pilotages 16 mettent en œuvre des composants de type transistors et lorsque le niveau haut est appliqué à la ligne L, celle-ci présente une impédance plus basse que lorsque le niveau bas est appliqué à la ligne L. Comme indiqué précédemment, l'impédance la plus haute peut entrainer des variations locales de potentiel sur la ligne. Ces variations peuvent être source de perturbations dans l'image issue du détecteur 12.

Les modules d'impédance 22 sont configurés pour abaisser l'impédance des conducteurs de ligne L lors de l'émission des signaux au niveau bas. Plus précisément, pour chaque ligne i, tant que le module de pilotage 16 correspondant émet un signal de sélection de ligne au niveau bas, le module d'impédance 22 maintient la ligne correspondante en basse impédance. Les modules d'impédance 22 sont disjoints des modules de pilotage.

Les modules d'impédance 22 sont avantageusement disposés du côté opposé de celui occupé par les modules de pilotage 16. Autrement dit, chaque conducteur de ligne L comprend deux extrémités. Les modules de pilotage 16 sont connectés aux conducteurs de ligne L à une première des extrémités et les modules d'impédance 22 sont connectés à chacun des conducteurs de ligne L à une seconde des extrémités.

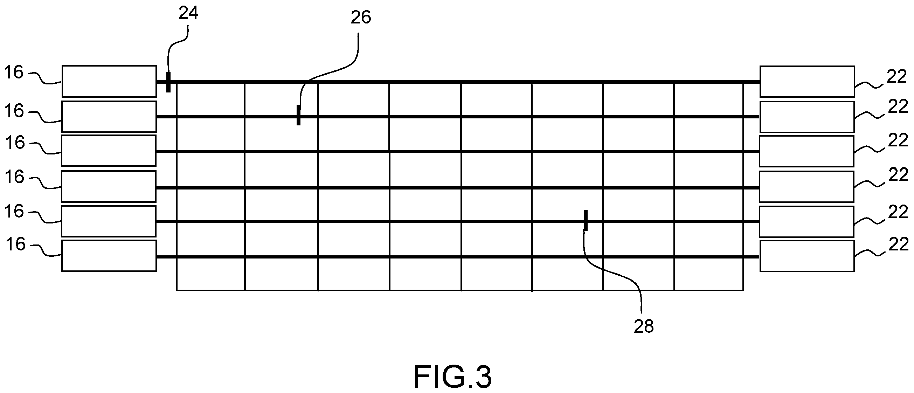

La figure 3 illustre cette disposition et ses avantages. Plus précisément, la figure 3 représente un détecteur comprenant 6 lignes et 8 colonnes de pixels P. Sur la partie gauche de la zone de détection 10 où les pixels P sont disposés, on retrouve les modules de pilotage 16 et sur la partie droite, les modules d'impédance 22. Lors de la fabrication du détecteur ou durant son utilisation des coupures de lignes L peuvent apparaitre.

Les coupures peuvent être involontaires, en cas de défaut de fabrication, ou intentionnelle lorsque la coupure sert à réparer un défaut ou à minimiser son impact sur la qualité globale de l'image issue du détecteur 12. Sur la figure 3, trois coupures sont représentées. Une première coupure 24 apparait sur la première ligne entre un module de pilotage 16 et la zone de détection 10. Des coupures 26 et 28 apparaissent à l'intérieur de la zone de détection 10.

En l'absence de module d'impédance 22, la portion de ligne coupée opposée au module de pilotage 16 est électriquement flottante et son potentiel n'est pas fixé. Le potentiel de cette portion flottante peut à son tour venir perturber le potentiel des lignes, colonnes et pixels adjacents par couplage capacitif et par conséquent dégrader la qualité d'image issue du détecteur. Avec les modules d'impédance 22 disposés du côté opposé aux modules de pilotage 16, les portions de lignes isolées des modules de pilotage 16 ne sont plus flottantes et leur potentiel est fixé à une valeur déterminée par les modules d'impédance 22, par exemple une valeur correspondant à une absence de sélection de ligne. Il en résulte une amélioration de la qualité d'image issue du détecteur par la réduction des artefacts liés au risque de couplage de ces portions flottantes avec les éléments voisins, lignes, colonnes ou pixels. En conséquence, les pixels d'une ligne coupée, sont soit pilotés par le module de pilotage 16 associé au conducteur de ligne soit mis en basse impédance par le module d'impédance 22 également associé à la ligne quelle que soit la position de la coupure le long de la ligne.

La figure 2 représente la mise en œuvre de l'invention dans un détecteur comprenant une dalle 14 sur laquelle sont intégrés en complément des pixels, les modules de pilotage 16, et les modules d'impédance 22. Un tel niveau d'intégration impose d'utiliser une même technologie de transistors à la fois pour les pixels P, pour les modules de pilotage 16 et pour les modules d'impédance 22.

Il est également possible de mette en œuvre l'invention même si les modules de pilotage 16 ne sont pas intégrés sur la dalle 14. Dans cette variante, il est possible de réaliser des modules de pilotage 16 intégrant le maintien en basse impédance pour les deux niveaux de signaux VGon et VGoff en utilisant des technologies de transistor différentes. Cette variante présente néanmoins un intérêt pour stabiliser l'impédance de lignes coupées ce qui arrive fréquemment dans des détecteurs possédant un grand nombre de pixels.

Sur la figure 2, les modules d'impédance 22 sont disposés du côté opposé de celui occupé par les modules de pilotage 16. Alternativement, les modules d'impédance 22 peuvent être situés au voisinage des modules de pilotage 16, c'est-à-dire du même côté de la zone de détection 10 et plus précisément entre modules de pilotage 16 et la zone de détection 10. Cette disposition présente l'avantage de regrouper tous les composants de pilotage et d'impédance sur un même bord du détecteur 12. L'avantage relatif au maintien de l'impédance des lignes coupées disparait. Cependant, pour certaines applications, telles que la mammographie ou le contrôle non-destructif, il peut être intéressant de positionner la dernière colonne de pixels, la plus éloignée des modules de pilotage 16, au plus proche du bord externe du détecteur 12.

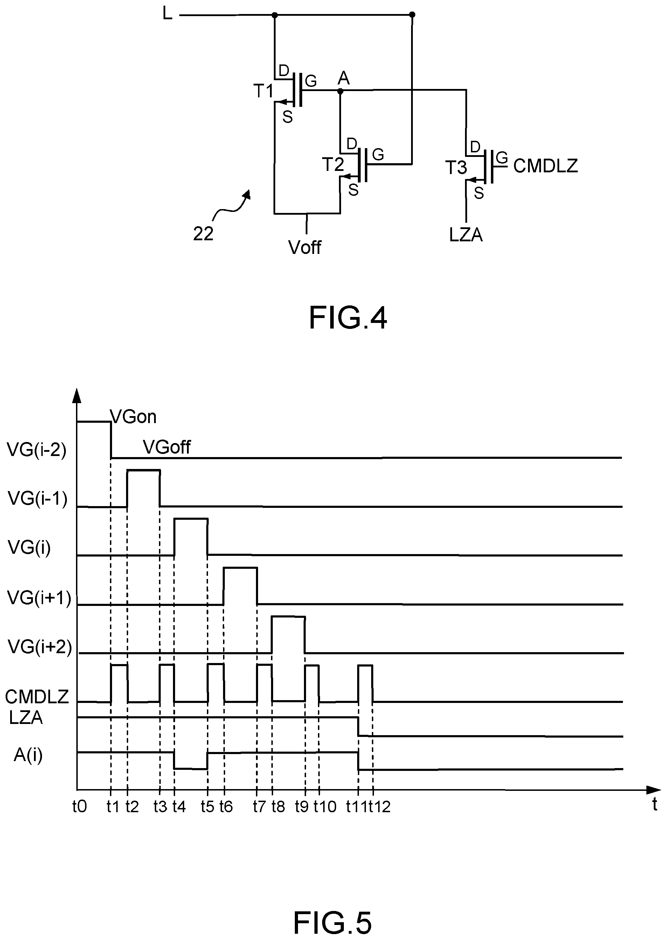

La figure 4 représente un exemple d'un module d'impédance 22 réalisé à partir de trois transistors en couches minces T1, T2 et T3. Le drain du transistor T1 est raccordé à la ligne L et sa source à une source de tension Voff correspondant au niveau bas VGoff du signal VG.

Durant la phase de lecture du détecteur, le module de pilotage 16 applique à la ligne L le signal VG soit au niveau haut VGon lorsque la ligne L est sélectionnée, soit au niveau bas VGoff lorsque la ligne L n'est pas sélectionnée. Le module de pilotage 16, notamment lorsqu'il est réalisé sur la dalle 14, peut également mettre en œuvre des transistors en couches minces pour appliquer le signal VG. Le niveau haut VGon est appliqué au travers d'un transistor plaçant la ligne L en basse impédance tandis que le niveau bas VGoff est appliqué en bloquant ce même transistor plaçant la ligne L en haute impédance.

Le module d'impédance 22 connecte la ligne L à la tension Voff lorsque la ligne L n'est pas sélectionnée, abaissant ainsi l'impédance du conducteur de ligne L au travers du transistor T1.

Les transistors T2 et T3 permettent le pilotage du transistor T1. Les drains des transistors T2 et T3 sont raccordés à la grille du transistor T1 formant un nœud A interne au module d'impédance 22. La ligne L est raccordée à la grille du transistor T2. La source du transistor T2 est raccordée à la source de tension Voff. La source du transistor T3 est raccordée à une commande LZA permettant de fixer le niveau du nœud A. La grille du transistor T3 est raccordée à une commande CMDLZ permettant de connecter le nœud A à la commande LZA.

La figure 5 illustre sous forme de chronogramme le fonctionnement du module d'impédance 22. Les signaux de sélection de ligne VG de cinq lignes consécutives de i-2 à i+2 sont représentés. Le signal VG(i-2) est au niveau haut VGon entre les instants t0 et t1. Après l'instant t1, le signal VG(i-2) est au niveau bas VGoff. La sélection des lignes suivantes s'enchaine ensuite de la même façon. Le signal VG(i-1) est au niveau haut VGon entre les instants t2 et t3. Le signal VG(i) est au niveau haut VGon entre les instants t4 et t5. Le signal VG(i+1) est au niveau haut VGon entre les instants t6 et t7. Enfin, le signal VG(i+2) est au niveau haut VGon entre les instants t8 et t9. Le signal CMDLZ passe au niveau haut pendant une courte durée avant la sélection de chaque ligne L, notamment entre les instants t3 et t4 pour la ligne i. Durant toute la phase de lecture, c'est-à-dire entre les instant t0 et t11, le signal LZA est au niveau haut. Hors de la phase de lecture, après l'instant t11 sur l'exemple représenté, le signal LZA est au niveau bas.

Lorsque la ligne i n'est pas sélectionnée, le nœud A reste à l'état haut, le transistor T1 est passant et le module d'impédance 22 maintient en basse impédance, le conducteur de ligne L(i) qui reste à la tension Voff.

Après le passage du signal CMDLZ au niveau haut avant la sélection de la ligne i, entre les instants t3 et t4, le transistor T3 devient non passant, ce qui place le nœud A en haute impédance.

Lorsque la ligne i est sélectionnée, la tension VGon est appliquée sur le conducteur de ligne L(i) ce qui rend le transistor T2 passant, faisant chuter au niveau bas le nœud A. Le transistor T1 devient non passant entre les instants t4 et t5. Le module d'impédance 22 ne modifie plus l'impédance du conducteur de ligne L(i).

Le signal CMDLZ peut être commun à toutes les lignes et monter au niveau haut avant chaque sélection de ligne. Le blocage du transistor T1 d'une ligne ne devient effectif que lorsque le conducteur de la ligne considéré reçoit le signal VG à l'état haut.

Une fois la phase de lecture terminée, après l'instant t11, lors de la phase d'acquisition du détecteur, le signal LZA est maintenu au niveau bas. Un dernier passage du signal CMDLZ par le niveau haut, entre les instants t11 et t12, permet de placer le nœud A au niveau bas en haute impédance, ce qui permet de placer les trois transistors T1, T2 et T3 à la tension Voff.

Comme on l'a vu précédemment, il est avantageux de réaliser sur la même dalle 14 l'ensemble 10 de pixels P, les modules de pilotage 16 et les modules d'impédance 22 afin de limiter les raccordements de la dalle 14 vers son environnement. Dans l'exemple de module d'impédance 22 de la figure 4, il est nécessaire de disposer un module par ligne de pixels. L'ensemble des modules d'impédance 22 peut être piloté par le circuit 20. Pour piloter L'ensemble des modules d'impédance 22, seuls les trois signaux Voff, CMDLZ et LZA doivent donc transiter du circuit 20 vers la dalle 14, ce qui simplifie les raccordements de la dalle 14.

La réalisation sur une même dalle 14 des pixels et des deux types de modules 16 et 22 se fait avantageusement en mettant en œuvre une seule technologie de transistor, notamment des transistors TFT en couches minces. Les transistors TFT mis en œuvre sur une dalle de verre supportent difficilement de rester longtemps à l'état passant. Cela entraine une dérive de leur tension de seuil et donc un vieillissement prématuré du détecteur. C'est pour cela qu'en dehors de la phase de lecture, les transistors sont placés à la tension Voff. Dans l'utilisation d'un détecteur à l'imagerie par rayons X, la phase de lecture de l'ensemble des pixels du détecteur occupe une durée de l'ordre de 1%, voire moins, de la durée d'utilisation du détecteur. Ce rapport peut être suffisant pour éviter un vieillissement prématuré du détecteur du fait des commutations des transistors TFT.

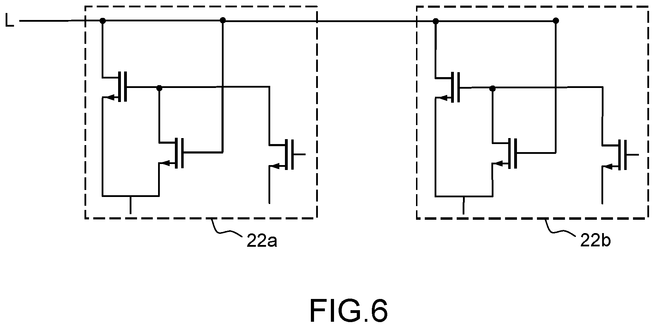

Il est possible de réduire encore le taux d'utilisation des transistors TFT en doublant les modules d'impédance 22. La figure 6 représente un exemple où deux modules d'impédances 22a et 22b sont connectés à un même conducteur de ligne L. Les deux modules 22a et 22b sont utilisés alternativement. Par exemple le module 22a est utilisé durant la lecture d'une image et le module 22b durant la lecture de l'image suivante. Cette réalisation permet de diviser par deux les durées pendant lesquelles les transistors sont à l'état passant. La durée de vie du détecteur est alors augmentée dans la même proportion.

Les modules d'impédance 22 représentés sur les figures 4 et 6 sont bien adaptés à une réalisation sur la même dalle de type TFT que la zone de détection 10. Il est bien entendu possible de mettre en œuvre l'invention avec d'autres technologies de transistors ou de réaliser la zone de détection 10 et les modules d'impédance 22 sur des dalles différentes.

Les modules d'impédance 22 peuvent par exemple être réalisés au moyen de portes logiques ET recevant le signal CMDLZ le signal VG et éventuellement le signal LZA. La sortie des modules d'impédance 22 pilotant l'arrêt de la mise en basse impédance de la ligne correspondante est obtenue lorsque le signal VG est au niveau haut et lorsque le signal CMDLZ est au niveau bas. D'autres façons de réaliser les modules d'impédance 22, comme par exemple en mettant en œuvre des registres à décalage, sont bien entendu possibles.

## Revendications

1. Détecteur matriciel comprenant :
• un ensemble (10) de pixels (P) sensibles à un phénomène physique et organisés en matrice selon des lignes et des colonnes, chaque pixel (P) générant un signal fonction du phénomène physique,
• des conducteurs de ligne (L) permettant chacun de piloter les pixels (P) d'une ligne,
• des modules de pilotage (16) délivrant des signaux de sélection (VG) aux conducteurs de ligne (L), les modules de pilotages (16) étant configurés pour délivrer des signaux selon deux niveaux dont un niveau haut (VGon) permettant la sélection de la ligne de pixels d'un conducteur de ligne et un niveau bas (VGoff) ne permettant pas sa sélection et plaçant le conducteur de ligne considéré en haute impédance,
**caractérisé en ce qu'**il comprend en outre des modules d'impédance (22) connectés à chacun des conducteurs de ligne (L) et configurés pour abaisser l'impédance de chaque conducteur de ligne (L) et maintenir en basse impédance chaque conducteur de ligne (L), pendant une phase de lecture de l'ensemble (10) de pixels (P), tant que le signal de sélection (VG) correspondant est au niveau bas (VGoff), les modules d'impédance (22) étant disjoints des modules de pilotage (16).

2. Détecteur matriciel selon la revendication 1, **caractérisé en ce que** chaque conducteur de ligne (L) comprend deux extrémités, **en ce que** les modules de modules de pilotage (16) sont connectés aux conducteurs de ligne (L) à une première des extrémités et **en ce que** les modules d'impédance (22) sont connectés à chacun des conducteurs de ligne (L) à une seconde des extrémités.

3. Détecteur matriciel selon l'une des revendications précédentes, **caractérisé en ce que** l'ensemble (10) de pixels (P), les modules de pilotage (16) et les modules d'impédance (22) sont réalisés sur le même substrat (14).

4. Détecteur matriciel selon l'une des revendications précédentes, **caractérisé en ce que** les modules d'impédance (22) comprennent chacun un transistor (T1) pouvant connecter la ligne correspondante à une source de tension (Voff) correspondant au niveau bas (VGoff) du signal de sélection lorsque la ligne (L) n'est pas sélectionnée, abaissant ainsi l'impédance de la ligne L au travers du transistor (T1).

5. Détecteur matriciel selon l'une des revendications précédentes, **caractérisé en ce que** l'ensemble (10) de pixels (P), les modules de pilotage (16) et les modules d'impédance (22) comprennent des transistors à couches minces.

6. Détecteur selon la revendication 5, **caractérisé en ce qu'**il comprend deux modules d'impédance (22a, 22b) par conducteur de ligne (L), les deux modules d'impédance (22a, 22b) pouvant être utilisés alternativement.

## Patentansprüche

1. Matrixdetektor, Folgendes umfassend:
• eine Gruppe (10) von Pixeln (P), welche einem physikalischen Phänomen gegenüber empfindlich und in einer Matrix in Zeilen und Spalten organisiert sind, wobei jeder Pixel (P) ein Signal angesichts des physikalischen Phänomens erzeugt,
• Zeilenleiter (L), welche es jeweils ermöglichen, die Pixel (P) einer Zeile zu steuern,
• Steuermodule (16), welche Auswahlsignale (VG) an die Zeilenleiter (L), abgeben, wobei die Steuermodule (16) konfiguriert sind, um Signale entsprechend zwei Pegeln abzugeben, darunter ein hoher Pegel (VGon), welcher die Auswahl der Pixelzeile eines Zeilenleiters ermöglicht, und ein niedriger Pegel (VGoff), welcher dessen Auswahl nicht ermöglicht und den betrachteten Zeilenleiter in hohe Impedanz versetzt,
**dadurch gekennzeichnet, dass** er ferner Impedanzmodule (22) umfasst, welche an einen jeden der Zeilenleiter (L) angeschlossen und konfiguriert sind, um die Impedanz eines jeden Zeilenleiters (L) zu senken und jeden Zeilenleiter (L) während einer Phase der Lektüre der Gruppe (10) von Pixeln (P) auf niedriger Impedanz zu halten, solange das entsprechende Auswahlsignal (VG) auf dem niedrigen Pegel (VGoff) steht, wobei die Impedanzmodule (22) von den Steuermodulen (16) getrennt sind.

2. Matrixdetektor nach Anspruch 1, **dadurch gekennzeichnet, dass** jeder Zeilenleiter (L) zwei Enden umfasst, dadurch, dass die Steuermodule (16) an die Zeilenleiter (L) an einem ersten der Enden angeschlossen sind und dadurch, dass die Impedanzmodule (22) an einen jeden der Zeilenleiter (L) an einem zweiten der Enden angeschlossen sind.

3. Matrixdetektor nach einem der vorhergehenden Ansprüche, **dadurch gekennzeichnet, dass** die Gruppe (10) von Pixeln (P), die Steuermodule (16) und die Impedanzmodule (22) auf demselben Substrat (14) hergestellt sind.

4. Matrixdetektor nach einem der vorhergehenden Ansprüche, **dadurch gekennzeichnet, dass** die Impedanzmodule (22) jeweils einen Transistor (T1) umfassen, welche die entsprechende Zeile an eine Spannungsquelle (Voff) anschließen kann, welche dem niedrigen Pegel (VGoff) des Auswahlsignals entspricht, wenn die Zeile (L) nicht ausgewählt ist, wodurch die Impedanz der Zeile L über den Transistor (T1) gesenkt wird.

5. Matrixdetektor nach einem der vorhergehenden Ansprüche, **dadurch gekennzeichnet, dass** die Gruppe (10) von Pixeln (P), die Steuermodule (16) und die Impedanzmodule (22) Dünnschichttransistoren umfassen.

6. Detektor nach Anspruch 5, **dadurch gekennzeichnet, dass** er zwei Impedanzmodule (22a, 22b) pro Zeilenleiter (L) umfasst, wobei die beiden Impedanzmodule (22a, 22b) abwechselnd verwendet werden können.

## Claims

1. Matrix detector comprising:
• an array (10) of pixels (P) that are sensitive to a physical effect and arranged in a matrix along rows and down columns, each pixel (P) generating a signal according to the physical effect;
• row conductors (L), each allowing the pixels (P) of one row to be driven;
• driver modules (16) delivering selection signals (VG) to the row conductors (L), the driver modules (16) being configured to deliver signals according to two levels, one being a high level (VGon) allowing one of the rows of pixels of a row conductor to be selected and the other being a low level (VGoff) not allowing it to be selected and setting the row conductor of interest to a high impedance;
**characterized in that** it further comprises impedance modules (22) that are connected to each of the row conductors (L) and configured to decrease the impedance of each row conductor (L) and to keep the impedance of each row conductor (L) low in a phase of reading the array (10) of pixels (P) as long as the corresponding selection signal (VG) is at the low level (VGoff), the impedance modules (22) being separate from the driver modules (16).

2. Matrix detector according to claim 1, **characterized in that** each row conductor (L) comprises two ends, **in that** the driver modules (16) are connected to the row conductors (L) at a first of the ends and **in that** the impedance modules (22) are connected to each of the row conductors (L) at a second of the ends.

3. Matrix detector according to one of the preceding claims, **characterized in that** the array (10) of pixels (P), the driver modules (16) and the impedance modules (22) are formed on the same substrate (14).

4. Matrix detector according to one of the preceding claims, **characterized in that** the impedance modules (22) each comprise a transistor (T1) that is able to connect the corresponding row to a voltage source (Voff) corresponding to the low level (VGoff) of the selection signal when the row (L) is not selected, thus decreasing the impedance of the row (L) through the transistor T1.

5. Matrix detector according to one of the preceding claims, **characterized in that** the array (10) of pixels (P), the driver modules (16) and the impedance modules (22) comprise thin-film transistors.

6. Detector according to Claim 5, **characterized in that** it comprises two impedance modules (22a, 22b) per row conductor (L), the two impedance modules (22a, 22b) being able to be used in alternation.
